# DEMANDE DE BREVET EUROPEEN

(11) **EP 4 261 871 A1**
(43) Date de publication de la demande: **18.10.2023**
(21) Numéro de dépôt: 23165429.4
(22) Date de dépôt: 30.03.2023
(51) Int. Cl.: H01L 21/285, H01L 21/768, H01L 23/528

(54) **CIRCUIT INTÉGRÉ COMPORTANT UN PILIER MÉTALLIQUE EN CONTACT AVEC UNE RÉGION EN SILICIUM SUR UNE RÉGION DE COUPLAGE OHMIQUE, ET PROCÉDÉ DE FABRICATION CORRESPONDANT**

(30) Priorité: 11.04.2022 FR 2203300
(71) Demandeur: STMicroelectronics Crolles 2 SAS, 38920 Crolles (FR)
(72) Inventeur: GREGOIRE, Magali, 38920 CROLLES (FR); SCHMITT, Joel, 38530 CHAPAREILLAN (FR)
(74) Mandataire: Casalonga

(57) **Abrégé**

Le procédé de fabrication de circuit intégré (200) comprend une formation d'au moins une région en silicium (TG, PSUB) et une formation d'au moins un pilier métallique (CNT) en contact avec ladite région en silicium sur une région de couplage ohmique (RCPL), la formation du pilier métallique comprenant :- une étape (204) de dépôt d'une couche de titane (Ti) sur la région en silicium (TG, PSUB) ; - une étape (206) de dépôt de couches atomiques de nitrure de titane (TiN) sur la couche de titane (Ti) ; - une étape (208) de recuit à une température comprise entre 715 °C et 815 °C pendant une durée comprise entre 5 secondes et 30 secondes.

La région de couplage ohmique (RCPL) du circuit intégré comprend du siliciure de titane dans un volume ayant une allure de calotte ou segment sphérique.

## Description

Des modes de réalisation et mise en oeuvre concernent les circuits intégrés, et les procédés de fabrication de circuits intégrés, en particulier les formations de régions de couplage ohmique entre un pilier métallique et une région en silicium.

Les régions de couplages ohmiques, usuellement appelées « siliciure », sont créés par un procédé, usuellement appelé « siliciuration », de diffusion de métaux vers le silicium, ou de diffusion de silicium vers le métal, ou de diffusion des deux espèces l'une vers l'autre, de manière à former un composé de siliciure de métal dans une zone de contact entre le métal et le silicium. Les régions de couplages ohmiques permettent de réduire la résistance du contact ainsi que la barrière de Schottky, usuellement référencée dans certains types de dispositifs, tels que des dispositifs d'imageurs.

Dans les technologies d'imageurs du type à obturation globale (usuellement « Global Shutter » en anglais) en particulier, il existe une corrélation entre le rendement final des produits et la performance des contacts (c'est-à-dire la faible résistance et la fiabilité) avec des régions semiconductrices des pixels.

L'émergence de nouvelles technologies en trois-dimensions à illumination par la face arrière « 3D-BSI » (acronyme des termes anglais usuels « 3D-Back-Side Illumination ») introduit des besoins plus grands en matière de performance des contacts pour répondre aux nouvelles exigences des produits. En effet, dans les technologies avancées d'imageurs 3D-BSI, un courant d'obscurité élevé et des résistances élevées des contacts sur les grilles dans la zone du pixel sont connus pour être un problème limitant les performances du pixel. Il est connu que le courant d'obscurité est sensible au niveau de dopage de la jonction p-n, à la densité des défauts cristallins dans le silicium, mais aussi à la qualité des régions de couplages ohmiques dans la zone du pixel.

D'autre part, les techniques classiques de contacts sont typiquement conçues pour des caissons en silicium dopé de type N+ et ne permettent pas d'obtenir des résultats satisfaisants sur les régions dopées du type P+ et sur des régions de grilles appartenant aux pixels.

Ainsi, il existe un besoin de proposer des contacts à haute performance pour améliorer les performances globales et le rendement final des produits, en particulier les circuits intégrés d'imageurs.

En outre, les inventeurs ont constaté qu'il est préférable d'éviter des concentrations relativement élevées en oxygène dans les siliciures de métal des régions de couplages ohmiques qui sont suspectées de participer à l'engendrement du courant d'obscurité.

Selon un aspect, il est proposé à cet égard un circuit intégré comportant au moins une région en silicium et au moins un pilier métallique en contact avec ladite région en silicium sur une région de couplage ohmique, dans lequel la région de couplage ohmique comprend du siliciure de titane dans un volume ayant une allure de segment sphérique.

Préférentiellement, ledit volume a une allure de calotte sphérique. On notera qu'une calotte sphérique est un cas particulier de segment sphérique, et la forme d'une calotte sphérique correspond sensiblement à la forme d'une lentille optique.

Par « un volume ayant une allure de segment sphérique (ou de calotte sphérique) » on entend qu'une forme de segment sphérique (ou de calotte sphérique) est reconnaissable dans une observation microscopique (par exemple du type microscopie électronique à balayage, et/ou à transmission « S/TEM », éventuellement accompagnée d'une détection de rayon X à diffusion d'énergie « EDX »), c'est-à-dire par exemple qu'une interpolation de la courbure de la sphère comportant le segment sphérique (ou la calotte sphérique) peut être obtenue à une valeur finie avec un maximum de vraisemblance.

En d'autres termes, étant donné la nature matérielle, par exemple obtenue par diffusion de matière, du volume de la région de couplage ohmique, on ne limitera pas la lecture des termes « un volume ayant une allure de segment/calotte sphérique » à un objet purement mathématique ayant une forme parfaitement régulière et/ou selon des considérations abstraites telles qu'une courbure de rayon infini définissant un volume délimité par des plans.

Ainsi, par rapport aux réalisations classiques des régions de couplage ohmique ayant des allures typiquement fines et plates, ici l'allure est épaisse. L'allure de segment sphérique du volume comprenant le siliciure de titane traduit une diffusion des matériaux avec une meilleure isotropie, plus étendue et plus uniforme. Une conséquence de la meilleure isotropie, de la plus grande étendue et de la meilleure uniformité du volume de siliciure de métal est une diminution de la résistance du contact. Par exemple, la résistance du contact sur une région en silicium ou polysilicium dopée du type P+ peut être comprise entre 30% et 50% de la résistance d'un contact classique ayant une structure et une taille semblables à ce contact, mais une région de couplage ohmique classiquement fine et plate. Par exemple, la résistance du contact sur une région en silicium ou poly silicium dopée du type N+ peut être de l'ordre de 80% de la résistance d'un contact classique ayant une structure et une taille semblables à ce contact, mais une région de couplage ohmique classiquement fine et plate.

Selon un mode de réalisation, le volume de la région de couplage ohmique a une allure de segment sphérique de rayon de disque de base compris entre 45 nanomètres et 57 nanomètres, et de hauteur comprise entre 14 nanomètres et 26 nanomètres.

Géométriquement, un segment sphérique est le solide défini par le volume d'une boule compris entre deux plans parallèles. Les deux plans parallèles sont séparés d'une distance appelée hauteur, et sectionnent la boule en un grand disque de base par le plan le plus proche du centre de la boule, et en un petit disque de base par le plan le plus éloigné du centre de la boule. On appelle « calotte sphérique » le cas d'un segment sphérique à un seul disque de base lorsque l'un des deux plans est tangent à la boule. Le grand disque de base correspond matériellement à la surface située au fond du pilier métallique. La hauteur correspond en pratique à l'épaisseur maximale (verticalement) du volume, sensiblement située au centre des disques de base.

Selon un mode de réalisation, la région de couplage ohmique comprend des atomes d'oxygène en proportions inférieures à 10 % (en pourcentage atomique).

Selon un mode de réalisation, la région de couplage ohmique comprend des atomes de silicium en proportions comprises entre 60 % et 80 % (en pourcentages atomiques).

Ces modes de réalisation correspondent à une composition de siliciure de titane ayant une meilleure pureté que les compositions classiques, et une stoechiométrie plus proche du disiliciure de titane TiSi₂ que les compositions classiques.

Selon un mode de réalisation, la région de couplage ohmique comprend une couche de nitrure de titane et la couche de siliciure de titane, la partie la plus épaisse de la couche de nitrure de titane ayant une épaisseur comprise entre 5 nanomètres et 6 nanomètres, et la partie la plus épaisse de la couche de siliciure de titane ayant une épaisseur comprise entre 9 nanomètres et 20 nanomètres.

Selon un mode de réalisation, le circuit intégré comporte en outre une matrice de pixels photosensibles, dans lequel la région en silicium est située dans la matrice de pixels photosensibles.

En effet, la région de couplage ohmique présente des performances en matière de résistance et de fiabilité, adaptées aux contraintes des dernières technologies d'imageurs. En particulier, les performances de la région de couplage ohmique permettent de contribuer à réduire le courant d'obscurité des pixels (c'est-à-dire un courant parasite généré par une photodiode en absence de lumière).

Selon un mode de réalisation, lesdits pixels photosensibles comportent des grilles de transfert et/ou des grilles de transistors et/ou des grilles verticales enterrées dans un substrat, et la région en silicium est une grille de transfert ou une grille d'un transistor ou une grille verticale enterrée dans le substrat.

Selon un mode de réalisation, la région en silicium est du silicium dopé du type P+ avec une concentration de dopants du type P supérieure à 10¹⁸ atomes par centimètre-cube.

Selon un mode de réalisation, le circuit intégré est assemblé dans une intégration à trois dimensions de deux puces superposées.

Là-encore, la région de couplage ohmique présente des performances en matière de résistance et de fiabilité, adaptées aux contraintes des dernières technologies d'intégration à trois dimensions de deux puces superposées, par exemple pour des imageurs du type « 3D-BSI » (pour « 3 Dimensions Back Side Illumination » en anglais).

Selon un autre aspect, il est également proposé un procédé de fabrication de circuit intégré comprenant une formation d'au moins une région en silicium et une formation d'au moins un pilier métallique en contact avec ladite région en silicium sur une région de couplage ohmique, la formation du pilier métallique comprenant :
- une étape de dépôt d'une couche de titane sur la région en silicium ;
- une étape de dépôt de couches atomiques de nitrure de titane sur la couche de titane ;
- une étape de recuit à une température comprise entre 715 °C et 815 °C pendant une durée comprise entre 5 secondes et 30 secondes.

Les étapes de formation du pilier métallique selon cet aspect permettent notamment d'obtenir la structure particulière de la région de couplage ohmique comprenant du siliciure de titane dans un volume ayant une allure de segment sphérique, ou préférentiellement une allure de calotte sphérique, définie ci-avant.

En particulier, l'étape de dépôt du nitrure de titane, par une technique de dépôt de couches atomiques (usuellement « ALD » pour « Atomic Layer Déposition » en anglais), forme une couche dense et riche en azote (nitrure). L'étape de recuit a une plus grande température et une durée plus longue que des conditions typiques des fabrications de contacts classiques, et permet, en combinaison avec le dépôt de la couche de nitrure de titane dense et riche en azote, une diffusion des matériaux avec une meilleure isotropie, plus étendue et plus uniforme de manière à former le siliciure de titane dans un volume ayant une allure de segment sphérique.

En outre, l'étape de dépôt du nitrure de titane par ALD contribue à obtenir des teneurs en oxygène inférieures à 10% dans la région de couplage ohmique, et contribue à obtenir des teneurs en silicium comprises entre 60% et 80% dans la région de couplage ohmique.

Selon un mode de mise en oeuvre, la formation du pilier métallique comprend une étape de préparation de surface par un plasma déporté de gaz de trifluorure d'azote et d'ammoniac sur la région en silicium, avant l'étape de dépôt de la couche de titane.

Un plasma déporté est un plasma déchargé électriquement, usuellement obtenu au moyen d'une grille métallique placée dans la chambre de réaction entre la génération du plasma et le dispositif traité, et permettant de capter les charges électriques du plasma. L'étape de préparation permet de retirer une couche d'oxyde « natif » sur la surface de ladite région en silicium, sans perturber électriquement la surface traitée, contribuant ainsi à l'amélioration de la résistance du contact.

Selon un mode de mise en oeuvre, la couche de titane déposée a une épaisseur comprise entre 17,5 nanomètres et 40 nanomètres, et la couche de nitrure de titane déposée a une épaisseur comprise entre 3 nanomètres et 6 nanomètres.

Cela permet notamment de former la région de couplage ohmique dans laquelle la partie la plus épaisse de la couche de nitrure de titane a une épaisseur comprise entre 5 nanomètres et 6 nanomètres, et la partie la plus épaisse de la couche de siliciure de titane a une épaisseur comprise entre 9 nanomètres et 20 nanomètres, telle que définie ci-avant.

Selon un mode de mise en oeuvre, la formation de ladite au moins une région en silicium est incluse dans une fabrication d'une matrice de pixels photosensibles.

Selon un mode de mise en oeuvre, la fabrication de la matrice de pixels photosensibles comprend des formations de grilles de transfert et/ou de grilles de transistors et/ou des grilles verticales enterrées dans un substrat, ladite au moins une région en silicium étant une grille de transfert ou une grille d'un transistor ou une grille verticale enterrée dans le substrat.

Selon un mode de mise en oeuvre, la formation de la région en silicium comprend une implantation de dopants de type P dans du silicium, avec une concentration supérieure à 10¹⁸ atomes de dopant par centimètre-cube.

Selon un mode de mise en oeuvre, l'étape de dépôt de la couche de titane comprend une utilisation d'une platine électrostatique pour maintenir une plaquette semiconductrice comportant le circuit intégré.

En effet, il a été découvert par sérendipité, lors de mises en oeuvre expérimentales du procédé défini ci-avant, que l'utilisation d'une platine électrostatique prévue pour maintenir la plaquette (usuellement « wafer » en anglais) contribue, de manière surprenante, à réduire le courant d'obscurité des pixels photosensibles. Une théorie pouvant expliquer ce phénomène est que les charges électrostatiques de la platine réduiraient la quantité de dipôles dans des défauts cristallins des régions photosensibles des pixels.

Selon un mode de mise en oeuvre, le procédé comprend en outre un assemblage du circuit intégré dans une intégration à trois dimensions de deux puces superposées.

D'autres avantages et caractéristiques de l'invention apparaîtront à l'examen de la description détaillée de modes de réalisation et de mise en oeuvre, nullement limitatifs, et des dessins annexés, sur lesquels :
[Fig.1A] ;
[Fig.1B] ;

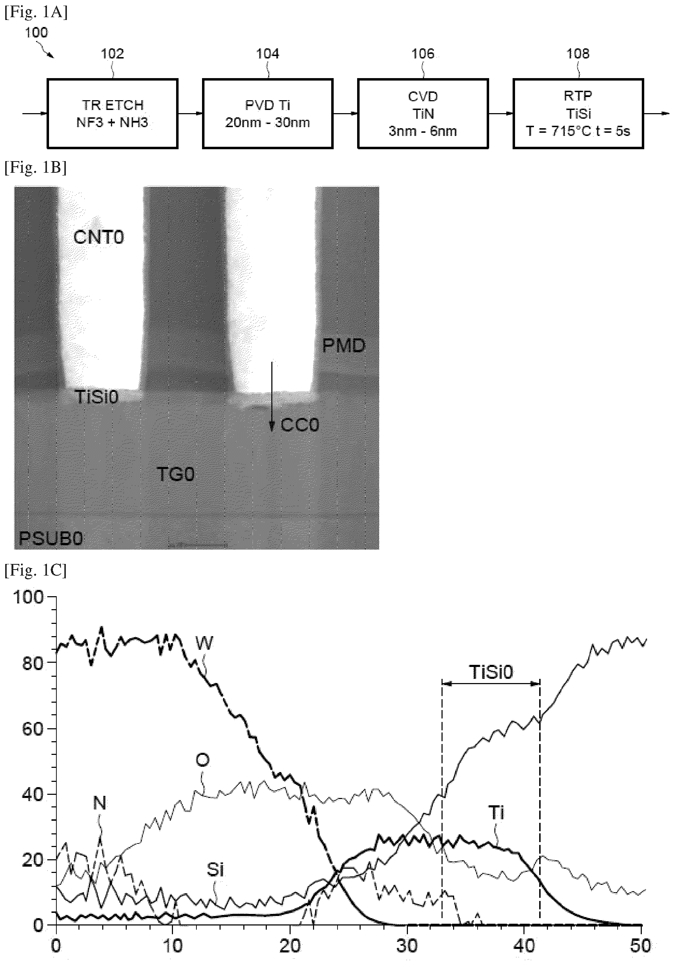

[Fig.1C] illustrent une référence à une technique classique de formation de contacts métalliques ;
[Fig.2A] ;
[Fig.2B] ;
[Fig.2C] ;
[Fig.3] ;
[Fig.4] ;
[Fig.5] ;

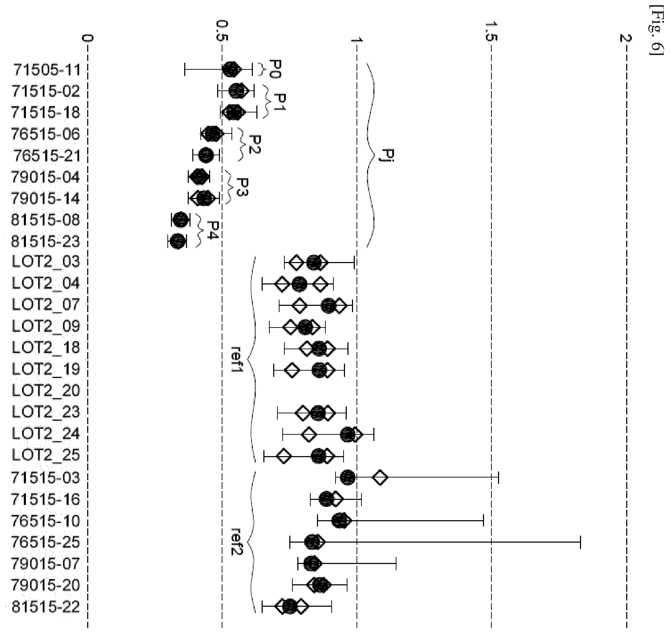

[Fig.6] illustrent des modes de réalisation et de mise en oeuvre de l'invention.

Les figures 1A, 1B et 1C, pour référence comparative, illustrent respectivement un procédé 100 de formation de piliers métalliques CNTO en contact avec une région en silicium TG0 sur une région de couplage ohmique TiSiO (figure 1A) ; une image de la structure obtenue par le procédé 100 issue d'une microscopie électronique en transmission (figure 1B) ; et une mesure des teneurs en matériaux le long de l'axe CC0 de la figure 1B (figure 1C).

Le procédé 100 comprend une étape de préparation 102 de la formation des piliers métalliques CNTO. L'étape 102 comprend une gravure de tranchées TR ETCH dans une ou des couche(s) diélectrique(s) pré-métal PMD située(s), dans le produit fini de circuit intégré, entre une partie semiconductrice PSUB0, TG0 et le premier niveau de métal d'un réseau d'interconnexion (usuellement « BEOL » pour « Back End Of Line » en anglais). La partie semiconductrice PSUB0, TG0 comporte des éléments à contacter électriquement avec les piliers CNTO, par exemple une grille de transistor TG0 en silicium polycristallin. Les tranchées gravées ont une forme sensiblement cylindrique, d'un diamètre compris entre 90 nm (nanomètres) et 115 nm, et une profondeur atteignant les éléments à contacter en silicium.

L'étape 102 peut comprendre en outre un « dégazage » sous plasma argon et une préparation surfacique par exposition du dispositif gravé, et notamment le silicium dans les ouvertures des tranchées à un plasma déporté, basé sur l'ionisation des gaz de trifluorure d'azote et d'ammoniac « NF₃+ NH₃ ».

Dans une étape 104, une première couche « barrière » en titane Ti est déposée sur les surfaces découvertes du dispositif gravé, c'est-à-dire en particulier sur les flancs et dans le fond des tranchées. La couche de titane est par exemple déposée par une technique de dépôt physique en phase vapeur conventionnelle PVD (pour « Physical Vapor Déposition » en anglais) avec épaisseur sensiblement constante comprise entre 20 nm et 30 nm.

Dans une étape 106, une deuxième couche « barrière » en nitrure titane TiN est déposée par-dessus la couche de titane Ti. La couche de nitrure de titane TiN est par exemple déposée par une technique de dépôt chimique en phase vapeur conventionnelle CVD (pour « Chemical Vapor Déposition » en anglais) sur une épaisseur sensiblement constante comprise entre 3 nm et 6 nm.

Dans une étape 108, un recuit conventionnel, par exemple appelé procédé thermique rapide RTP (pour « Rapid Thermal Process » en anglais), chauffe le dispositif ainsi obtenu à une température T = 715 °C (degrés Celsius) pendant une durée t = 5s (secondes). Le recuit permet de faire diffuser le titane des couches barrières dans la région en silicium TG0, de manière à former un composé de siliciure de titane TiSiO. Une diffusion des atomes de silicium se produit également dans la couche en silicium TG0. Le composé de siliciure de métal est destiné à améliorer la qualité du couplage ohmique entre le pilier CNTO et le silicium TG0, c'est-à-dire destiné à réduire la résistance du couplage.

Enfin, les tranchées recouvertes sur leurs fonds et leurs flancs des couches barrières sont remplies par un métal, typiquement du tungstène, et des techniques de nivellement (par exemple une planarisation chimio-mécanique CMP pour « Chemical Mechanical Planarization » en anglais) permettent de retirer l'excédent en métaux sur le dessus de la couche diélectrique pré-métal PMD.

Il est visible sur l'image de la figure 1B, dans cet exemple une microscopie électronique en transmission« TEM » (pour « Transmission Electron Microscopy » en anglais) de la structure obtenue par le procédé 100, le volume de siliciure de titane a une allure plate, sensiblement cylindrique, selon un diamètre compris entre 90 nm et 115 nm et une épaisseur inférieure à 8 nm.

La figure 1C, représentant la mesure des teneurs (c'est-à-dire les concentrations rapportées en pourcentages atomiques) des différents matériaux de la structure obtenue par le procédé 100 le long de l'axe CC0 de la figure 1B, par exemple obtenue par spectroscopie de rayons X à dispersion d'énergie « EDX » (pour « Energy-Dispersive X-ray » en anglais). Il est visible sur la figure 1C que la couche de siliciure de métal TiSiO, située entre approximativement 32 nm et 41 nm sur l'axe CC0, comporte près de 20 % d'atomes d'oxygène.

La faible épaisseur (inférieure à 8 nm) et la haute teneur en oxygène (proche de 20 %) de la couche de siliciure de métal TiSiO contribuent aux contraintes limitant la réduction souhaitée de la résistance du contact entre le pilier métallique CNTO et la grille en silicium TG0.

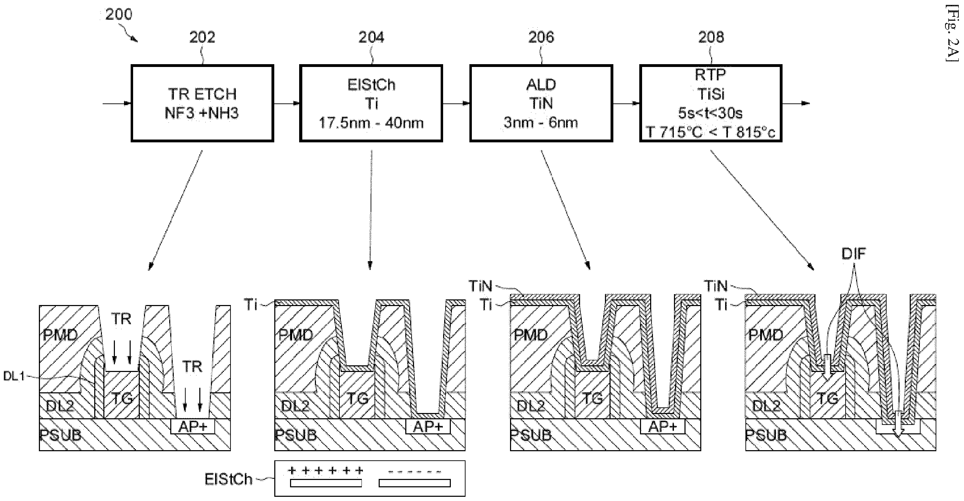

La figure 2A illustre un procédé 200 permettant d'améliorer les performances des contacts entre des piliers métalliques et des régions en silicium TG, P+, notamment en matière de résistance électrique des contacts.

Le procédé 200 comprend une étape de préparation 202 similaire à l'étape de préparation 102 du procédé de référence. L'étape 202 comprend ainsi une gravure de tranchées TR ETCH dans des couches diélectriques pré-métal PMD, DL2, DL1 situées sur une partie semiconductrice PSUB, TG, AP+. La partie semiconductrice est fabriquée préalablement sur un substrat semiconducteur PSUB, typiquement en silicium, et comporte une grille de transfert TG, structurellement assimilable à une grille de transistor, et une région fortement dopée AP+ implantée dans le substrat PSUB, par exemple une anode d'une photodiode.

Par « région fortement dopée » on entend une région dopée dont la concentration en dopants est supérieure à 10¹⁸ atomes par centimètre-cube.

La grille de transfert TG et l'anode AP+ sont destinées à être contactées par des piliers métalliques et des tranchées TR sont formées en regard de ces régions en silicium TG, AP+. Les tranchées gravées ont une forme sensiblement cylindrique, d'un diamètre compris entre 90 nm et 115 nm, et une profondeur atteignant les éléments à contacter en silicium.

L'étape 202 peut également comprendre en outre un « dégazage » sous plasma argon et une préparation surfacique par exposition du dispositif gravé, et notamment le silicium dans les ouvertures des tranchées à un plasma déporté basé sur l'ionisation des gaz de trifluorure d'azote et d'ammoniac NF₃ + NH₃.

Dans une étape 204, une première couche dite « barrière » en titane Ti est déposée sur les surfaces découvertes du dispositif gravé, c'est-à-dire en particulier sur les flancs et dans le fond des tranchées TR. La couche de titane Ti est avantageusement déposée par une technique de dépôt physique en phase vapeur PVD dans un réacteur muni d'une platine de maintien électrostatique ElStCh (usuellement « electrostatic chuck » en anglais) du substrat PSUB.

La platine de maintien électrostatique ElStCh est un dispositif adapté pour maintenir le substrat PSUB du circuit intégré (à cette étape du procédé 200, le circuit intégré appartient à une plaquette, usuellement appelée « wafer » en anglais), dans la chambre du réacteur permettant le dépôt 204 de la couche en titane Ti. La plaquette est maintenue par une force électrostatique, c'est-à-dire la force de Coulomb, se produisant en réponse à des tensions alternatives de l'ordre de - 400 V (Volts) et + 400 V dans des électrodes internes de la platine.

En outre, la couche de titane Ti est déposée sur une épaisseur sensiblement constante comprise entre 17,5 nm et 40 nm.

Dans une étape 206, une deuxième couche dite « barrière » en nitrure titane TiN est déposée sur la couche de titane Ti. La couche de nitrure de titane TiN est déposée par une technique de dépôt de couche atomique ALD (pour « Atomic Layer Déposition » en anglais) sur une épaisseur constante comprise entre 3 nm et 6 nm.

La technique de dépôt de couche atomique ALD est une variante particulière de dépôt chimique en phase vapeur CVD, produisant dans le cas précis d'un dépôt du nitrure de titane TiN un matériau très pur, de très forte densité et parfaitement stochiométrique, ce qui lui confère une imperméabilité significativement plus grande à l'atmosphère ambiante (notamment à l'oxygène) par rapport à des procédés de dépôt chimique en phase vapeur conventionnels.

Ainsi, l'étape 206 de dépôt de couche atomique ALD résulte à une formation de la couche de nitrure de titane TiN plus dense et plus pure que les procédés de CVD conventionnels. En conséquence, des impuretés d'atomes d'oxygène sont présentes à des teneurs inférieures à 10 %, voire inférieures à 5 %, dans le dépôt de couche atomique ALD du nitrure de titane TiN, tandis que l'oxygène peut avoir une teneur de l'ordre de 20 % dans les techniques de CVD conventionnelles.

Dans une étape 208, un recuit, plus long et/ou plus chaud que lors de l'étape conventionnelle 108 mais pouvant également être appelé procédé thermique rapide RTP, chauffe le dispositif ainsi obtenu à une température T comprise entre 715 °C et 815 °C (715 °C≤ T ≤815 °C) pendant une durée t comprise entre 5 s et 30 s (5 s ≤ t ≤ 30 s). Préférentiellement, la température T est comprise entre 740 °C et 790 °C et la durée t est comprise entre 10 s et 30 s. Encore plus préférentiellement, la température T est comprise entre 760 °C et 770 °C par exemple 765 °C, et la durée t est comprise entre 10 s et 20 s, par exemple 15 s.

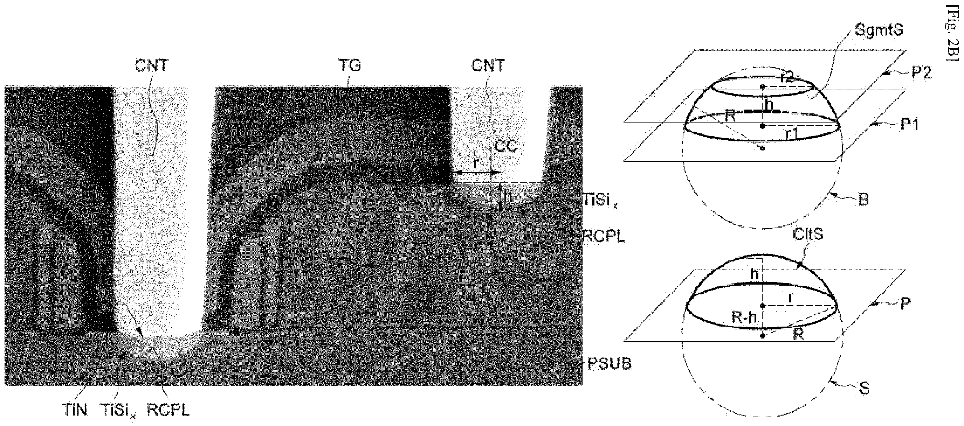

Le recuit permet de faire diffuser le titane des couches barrières dans les régions en silicium TG, AP+, de manière à former un composé de siliciure de titane TiSiₓ (figure 2B) dans une région de couplage ohmique RCPL (figure 2B) particulièrement avantageuse pour les performances du contact.

En effet, la technique de dépôt de couches atomiques ALD 206 du nitrure de titane TiN forme une couche dense et riche en azote (nitrure), et l'étape de recuit 208 à une plus grande température et d'une durée plus longue que des conditions du procédé de référence 100 permettent une diffusion des matériaux avec une meilleure isotropie, plus étendue et plus uniforme, de manière à former le siliciure de titane dans un volume ayant une allure de segment sphérique, ou préférentiellement de calotte sphérique. On se référera à cet égard à la description ci-après en relation avec la figure 2B.

Enfin, les tranchées recouvertes sur leurs fonds et leurs flancs des couches barrières sont remplies par un métal, par exemple du tungstène, et l'excédent en métaux est retiré par des techniques de nivellement pour former les piliers métalliques CNT (figure 2B).

La figure 2B illustre une image de microscopie électronique en transmission « TEM » de la structure obtenue par le procédé 200 décrit ci-avant en relation avec la figure 2A, les éléments communs supportent les mêmes références et ne seront pas tous détaillés à nouveau.

Les piliers métalliques CNT sont en contact avec des régions en silicium, par exemple une grille de transfert TG et une région du substrat PSUB, sur une région de couplage ohmique RCPL obtenue à l'issue de l'étape de recuit 208. La région de couplage ohmique RCPL a un volume ayant une allure de calotte sphérique et comprend en particulier du siliciure de titane TiSix

Le volume de la région de couplage ohmique RCPL peut comprendre la couche de nitrure de titane TiN et la composition de siliciure de titane TiSix.

Un segment sphérique SgmtS, géométriquement représentée à côté de l'image de microscopie de la figure 2B, est le solide défini par le volume d'une boule B compris entre deux plans parallèles P1, P2. Les deux plans parallèles P1, P2 sont séparés d'une distance appelée hauteur h. Le plan P1 le plus proche du centre C de la boule B sectionne la boule en un grand disque de base de rayon r1, tandis que le plan P2 le plus éloigné du centre C de la boule B sectionne la boule en un petit disque de base de rayon r2.

Une calotte sphérique CltS, géométriquement représentée à côté de l'image de microscopie de la figure 2B, correspond à la plus petite des deux sections d'une sphère S par un plan P. L'intersection entre la sphère S et le plan P forme le cercle de base, de rayon r, de la calotte CltS. On considère que les termes « calotte sphérique » CltS désignent également le volume fermé (c'est-à-dire le solide) délimité par la surface de la calotte CltS et le disque de base du cercle de base. La calotte sphérique est également le cas particulier du segment sphérique à un seul (grand) disque de base, c'est-à-dire le cas particulier où le plan P2 est tangent à la boule B.

Etant donné la nature matérielle obtenue par diffusion de la région de couplage ohmique RCPL, la forme du volume de la région de couplage ohmique RCPL n'est pas parfaitement régulière comme sa définition mathématique l'entendrait. On exclura aussi des abstractions mathématiques, telles que des cas limites de plan P tangent à la sphère S (pour la définition de la calotte sphérique CltS), de sphère S ou boule B de rayon R infini, ou encore de deux plans P1, P2 identiques (pour la définition du segment sphérique SgmtS).

Aussi, afin d'éviter l'extrapolation d'une forme sensiblement cylindrique d'épaisseur fine à un cas de segment sphérique défini par des plans P1, P2 proches du centre C de la boule B et par une hauteur h égale à l'épaisseur du cylindre, on définit une allure de segment sphérique « reconnaissable » par un rayon r1 du grand disque de base inférieur à trois quarts (3/4) du rayon R de la boule B.

Comme sur l'image de microscopie de la figure 2B, une allure de segment sphérique est reconnaissable dans une observation du circuit intégré, c'est-à-dire qu'il est notamment possible de mesurer le rayon R de la boule B, le rayon r1 du grand disque de base (cas de la calotte sphérique), et éventuellement le rayon r2 du petit disque de base et la hauteur h du segment sphérique.

Par exemple en pratique, si le volume de la région de couplage ohmique RCPL a une allure de calotte sphérique, le rayon du cercle (ou disque) de base r est compris entre 45 nanomètres et 57 nanomètres, et la hauteur h est comprise entre 14 nanomètres et 26 nanomètres.

De manière analogue, si le volume de la région de couplage ohmique RCPL a une allure de segment sphérique, le rayon du grand disque de base r1 est compris entre 45 nanomètres et 57 nanomètres, et la hauteur h est comprise entre 14 nanomètres et 26 nanomètres.

La hauteur h peut par exemple correspondre à la couche de nitrure de titane TiN ayant une épaisseur comprise entre 5 nm et 6 nm dans sa partie la plus épaisse, et la couche de siliciure de titane TiSix ayant une épaisseur comprise entre 9 nm et 20 nm dans sa partie la plus épaisse. La couche de nitrure de titane TiN est néanmoins d'épaisseur sensiblement constante.

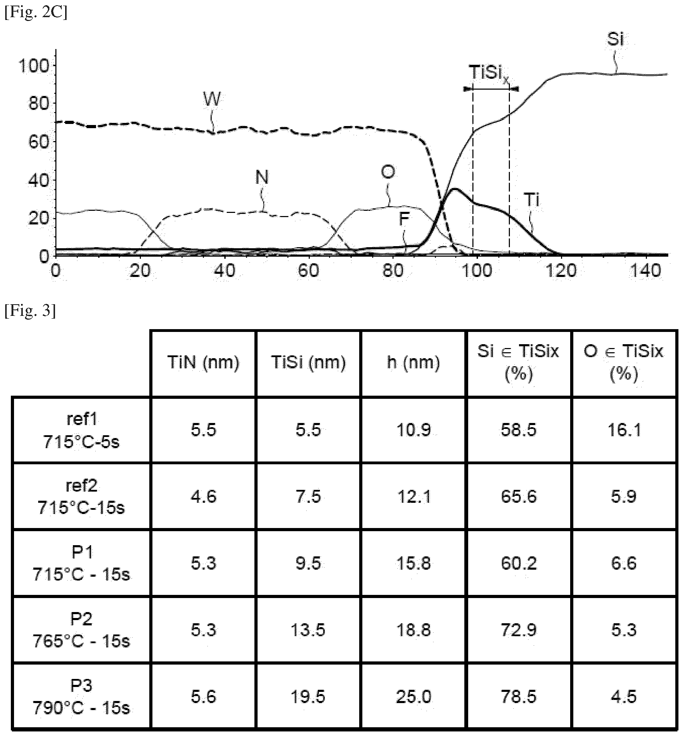

La figure 2C représente la mesure des teneurs des différents matériaux de la structure obtenue par le procédé 200 le long de l'axe CC de la figure 2B, par exemple également obtenue par spectroscopie de rayons X à dispersion d'énergie « EDX ». Il est visible sur la figure 2C que la couche de siliciure de métal TiSix, située entre approximativement 100 nm et 110 nm sur l'axe CC, comporte moins de 5 % d'atomes d'oxygène.

En conséquence et d'un autre point de vue, la région de couplage ohmique RCPL comporte des atomes de silicium en proportions comprises entre 60 % et 80 % et des atomes de titane en proportions comprises entre 20 % et 40 %, ce qui est avantageusement proche de stoechiométrie du disiliciure de titane TiSi₂.

La conséquence de l'allure de calotte ou segment sphérique du volume de la région de couplage RCPL, reflétant une meilleure isotropie, une plus grande étendue et une meilleure uniformité de la diffusion du siliciure de métal, ainsi que de la faible teneur en oxygène dans le siliciure de métal TiSix, est une diminution de la résistance du contact. Par exemple, la résistance du contact peut être comprise entre 30% et 50% de la résistance du contact de référence TiSiO décrit en relation avec les figures 1A, 1B et 1C, dans le cas où la région en silicium est dopée du type P+, et de l'ordre de 80% si la région en silicium est dopée du type N+.

La figure 3 illustre un tableau tab1 comparatif entre certains paramètres structurels des dispositifs P1, P2, P3 obtenus par le procédé 200 (figures 2A, 2B et 2C) par rapport à des dispositifs ref1, ref2 obtenus par le procédé de référence 100 (figures 1A, 1B, 1C), en particulier en fonction de configurations de l'étape de recuit 108, 208.

Les données présentées dans le tableau tab1 sont des valeurs moyennes de mesures des paramètres structurels de la région de couplage ohmique d'un produit fini. Les paramètres structurels présentés sont : l'épaisseur de la couche de nitrure de silicium TiN ; l'épaisseur de la couche de siliciure de titane TiSix ; la hauteur h du volume de la région de couplage ohmique (c'est-à-dire la hauteur d'un volume d'allure cylindrique pour ref1, ref2 et la hauteur h du volume d'allure de calotte ou segment sphérique pour P1, P2, P3) ; la teneur en atomes de silicium dans la couche de siliciure de titane Si ∈ TiSix ; et la teneur en atomes d'oxygène dans la couche de siliciure de titane O E TiSix.

L'étape de recuit 108 de la fabrication des premiers produits de référence ref1 a été faite à une température de 715 °C pendant une durée de 5 s.

L'étape de recuit 108 de la fabrication des deuxièmes produits de référence ref2 a été faite à une température de 715 °C pendant une durée de 15 s.

L'étape de recuit 208 de la fabrication des premiers produits P1 a été faite à une température de 715 °C pendant une durée de 15 s.

L'étape de recuit 208 de la fabrication des deuxièmes produits P2 a été faite à une température de 765 °C pendant une durée de 15 s.

L'étape de recuit 208 de la fabrication des troisièmes produits P3 a été faite à une température de 790 °C pendant une durée de 15 s.

On peut voir sur les données moyennes du tableau tab1 que l'augmentation de la température du recuit 208 se traduit par une augmentation de la hauteur h de la calotte ou segment sphérique RCPL de 15,8 nm, 18,8 nm et 25 nm, ou plus largement comprise entre 14 nm et 26 nm. On remarque cependant que l'épaisseur de nitrure de silicium TiN est sensiblement constante et similaire aux produits de références ref1, ref2, entre 5,3 nm et 5,6 nm, tandis que l'épaisseur de siliciure de titane TiSix augmente avec la température du recuit, de 9,5 nm, 13,5 nm et 19,4 nm. Ainsi l'étape de dépôt de couches atomiques de nitrure de titane 206 et le recuit 208 semblent contribuer majoritairement à l'obtention d'une meilleure isotropie, une plus grande étendue et une meilleure uniformité de la diffusion du siliciure de métal, traduites par l'allure de segment sphérique ou de calotte sphérique du volume de la région de couplage ohmique RCPL.

En outre, la teneur (en pourcentage atomique) en silicium augmente également avec l'augmentation de la température du recuit de 60,2 %, 72,9 % et 78,5 %, ou plus largement comprise entre 60 % et 80 %. Parallèlement, la teneur en oxygène est toujours très basse dans les produits P1, P2, P3, de 6,6%, 5,3% et 4,5%, c'est-à-dire inférieures à 10 % voire inférieure à 5 %.

Ces différents paramètres structurels sont liés et sont représentatifs de l'amélioration de la qualité de la région de couplage ohmique RCPL, et sont en outre particulièrement avantageux dans le cadre d'une réalisation de pixels photosensibles.

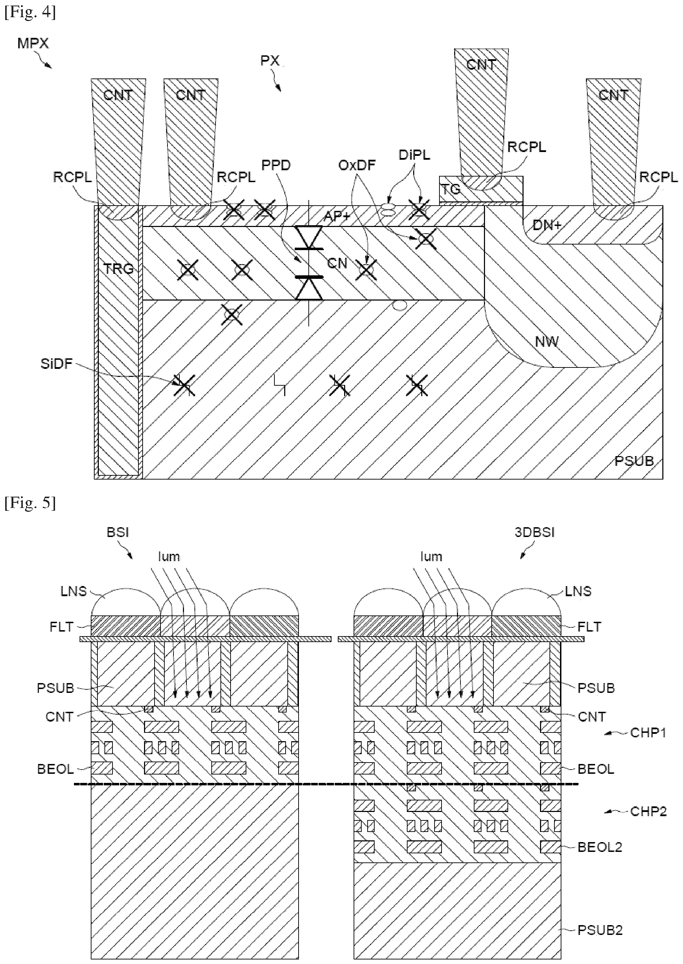

On se réfère à cet égard à la figure 4.

La figure 4 illustre schématiquement un pixel photosensible PX, appartenant usuellement à une matrice de pixels MPX, par exemple dans un dispositif de capture d'images.

Un pixel photosensible PX comporte une région semiconductrice photosensible, par exemple une photodiode pincée PPD (usuellement « pinned photodiode » en anglais), comportant une jonction pn entre le substrat PSUB de type P, typiquement en silicium, et un caisson CN dopé de type N. Le caisson CN de la photodiode pincée PPD forme une région de cathode complètement désertée par la présence d'une région AP+ fortement dopée du type P+, c'est-à-dire dopée de type P avec une concentration en dopant supérieure à 10¹⁸ cm⁻³, implantée peu profondément dans le caisson CN en surface du substrat PSUB.

Le pixel PX peut comporter en outre des éléments de lecture des charges photogénérés à la jonction pn, tels qu'une grille de transfert TG, un noeud de transfert DN+ et éventuellement une « photogrille » TRG ou des transistors « MOS » (« Métal Oxyde Semiconducteur » classique et connu en soi).

La grille de transfert TG est comparable à une grille de transistor MOS, réalisée en silicium polycristallin sur une couche d'oxyde de grille, à la différence qu'une grille de transfert TG n'est pas associée à des régions de conductions proprement dites. La grille de transfert TG permet d'abaisser une barrière de potentiel entre la diode et par exemple le noeud de transfert DN+, pour faire migrer les charges photogénérés sans générer de courant.

Le noeud de transfert DN+ est par exemple réalisé sous la forme d'une région dopée du type N+, c'est-à-dire dopée de type N à une concentration supérieure à 10¹⁸cm⁻³, dans un caisson NW dopé de type N.

Le terme « photogrille » correspond à une grille verticale enterrée TRG, s'étendant verticalement en profondeur dans le substrat PSUB. La grille verticale enterrée TRG remplit une tranchée avec un volume de silicium polycristallin dans une enveloppe diélectrique.

Ainsi, le pixel photosensible PX et la matrice de pixels photosensibles MPX comportent au moins une région en silicium parmi : des grilles de transfert TG ; des grilles de transistors (structurellement similaires à la grille de transfert TG) ; des grilles verticales enterrées TRG ; des régions implantés AP+ du type P+ ; et des régions implantées DN+ du type N+ ; par exemple en fonction de la technologie des pixels PX.

Ces différentes régions en silicium TG, TRG, N+, P+, peuvent chacune être destinée à être contactées par un pilier métallique CNT sur la région de couplage ohmique RCPL comprenant du siliciure de titane dans un volume ayant une allure de calotte ou segment sphérique, tel que décrit précédemment en relation avec les figures 2A, 2B, 2C, et 3.

En effet, la région de couplage ohmique RCPL présente des performances en matière de résistance et de fiabilité, adaptées aux contraintes des dernières technologies d'imageurs. En particulier, les performances des régions de couplages ohmiques RCPL permettent de contribuer à réduire le courant d'obscurité des pixels PX. Le courant d'obscurité est un courant parasite généré par la photodiode PPD en absence de lumière.

D'autre part, les régions de couplages ohmiques RCPL présentent des performances en matière de résistance et de fiabilité adaptées aux contraintes des dernières technologies d'intégration à trois dimensions de deux puces superposées, par exemple pour des imageurs du type « 3D-BSI ».

On se réfère à cet égard à la figure 5.

La figure 5 illustre une technologie d'imageur à illumination par la face arrière BSI, et une technologie d'imageur à illumination par la face arrière dans une intégration à trois dimensions de deux puces superposées 3DBSI.

L'imageur à illumination par la face arrière BSI comporte une matrice de pixels photosensibles du type de la matrice MPX décrite en relation avec la figure 4. La face arrière du substrat PSUB comportant la matrice MPX est destinée à recevoir un flux de lumière lum et est recouvert à cet égard d'un réseau de lentilles LNS et de filtre FLT, typiquement rouges, verts et bleus.

Les piliers métalliques CNT en contact, sur les régions de couplages ohmiques RCPL, avec les différentes régions en silicium TG, TRG, N+, P+, appartiennent à une partie d'interconnexions BEOL.

Dans la technologie d'imageur à illumination par la face arrière dans une intégration à trois dimensions de deux puces superposées 3DBSI, une première puce CHP1, sensiblement identique au dispositif d'imageur à illumination par la face arrière BSI, est assemblée avec une seconde puce CHP2, au niveau de leurs parties d'interconnexions respectives BEOL, BEOL2. Le substrat PSUB2 de la seconde puce CHP2 peut par exemple comporter des circuits de traitements des signaux d'images performants, sans augmenter la taille, en termes de surface, du dispositif global 3DBSI.

La technologie en trois-dimensions à illumination par la face arrière 3DBSI introduit des besoins plus grands en matière de performance des contacts CNT, RCPL pour répondre aux exigences des produits, plus performants. Et, les régions de couplages ohmiques RCPL décrites ci-avant en relation avec les figures 2A, 2B, 2C, 3 et 4 sont compatibles avec les exigences des technologies en trois-dimensions à illumination par la face arrière 3D-BSI.

En outre, il a été découvert par sérendipité que la fabrication des régions de couplages RCPL selon le procédé 200 décrit en relation avec la figure 2A permet de réduire, de manière beaucoup plus grande qu'attendue, le courant d'obscurité du dispositif d'imageur à partir duquel est mise en oeuvre cette fabrication 200.

On se réfère à cet égard à la figure 6.

La figure 6 illustre des mesures du courant d'obscurité des pixels pour des dispositifs d'imageurs Pj comprenant des régions de couplages RCPL fabriquées selon le procédé 200, et pour des dispositifs d'imageurs identiques du point de vue des pixels, mais comprenant des régions de couplages RCPL fabriquées selon le procédé 100 de référence, ref1, ref2, tels que décrits précédemment en relation avec la figure 3.

L'échelle du courant d'obscurité (en ordonnée) est normalisée par un indice sans dimension, le pire cas des dispositifs d'imageurs de référence ref1, ref2 étant positionné à l'indice 1. Toutes les mesures du courant d'obscurité des dispositifs d'imageurs de référence ref1, ref2 sont proches de 1, approximativement comprises entre 0,75 et 1.

Les mesures du courant d'obscurité des dispositifs d'imageurs Pj fabriqués avec le procédé 200 sont quant à elles proches de l'indice 0,5, approximativement comprises entre 0,3 et 0,55. Le courant d'obscurité est ainsi sensiblement divisé par 2 par rapport aux procédés de référence ref1, ref2.

Les dispositifs des populations P1, P2, P3 sont fabriqués dans les conditions décrites précédemment en relation avec la figure 3.

Les dispositifs de la population P0 sont fabriqués avec des conditions de recuit 208 du procédé 200 décrit en relation avec la figure 2A qui correspondent aux conditions du recuit 108 du procédé de référence 100, c'est-à-dire une température T de 715 °C pendant une durée t de 5 s.

Les dispositifs de la population P4 sont fabriqués avec des conditions de recuit 208 du procédé 200 décrit en relation avec la figure 2A, à une température T de 815 °C pendant une durée t de 15 s.

La réduction du courant d'obscurité est plus grande avec l'augmentation de la température T, mais il existe un risque, en particulier au-dessus de 800 °C, de dégrader, voire détruire fonctionnellement, les diodes photosensibles PPD.

Ainsi, des conditions préférentielles de l'étape de recuit 208 du procédé 200 décrit en relation avec la figure 2A sont une température T de 765 °C pendant une durée t de 15 s, et une température T de 790 °C pendant une durée t de 15 s.

Comme mentionné précédemment, la réduction du courant d'obscurité provient notamment de l'amélioration de la qualité de la région de couplage ohmique RCPL, notamment en matière de diminution de la valeur résistive du couplage.

Cela étant, on estime que cette ampleur de la réduction du courant d'obscurité (division par 2) provient d'autres phénomènes physiques additionnels, liés à la région de couplage ohmique RCPL, et à la mise en oeuvre des étapes du procédé 200 décrit en relation avec la figure 2A.

On se réfère à cet égard de nouveau à la figure 4.

On estime en effet que trois autres phénomènes peuvent contribuer à la réduction du courant d'obscurité, en outre de la réduction de la résistance de la région de couplage ohmique RCPL.

Premièrement, il existe des dipôles DiPL dans des défauts se trouvant à l'interface entre le substrat PSUB, c'est-à-dire la surface de la région fortement dopée AP+, et la couche de diélectrique pré-métal qui la recouvre (non représentée). Ces dipôles contribuent à l'engendrement de fuites de courant dans la jonction pn de la diode PPD, faisant partie du courant d'obscurité. Or, il est possible et probable que la platine de maintien électrostatique ElStCh, utilisée dans l'étape 204 de dépôt de la couche de titane du procédé 200 décrit en relation avec la figure 2A, fasse disparaître les dipôles électriques dans les défauts d'interface sous l'influence des champs électriques (+/- 400 V) générés par la platine ElStCh.

Deuxièmement, il existe des défauts cristallins causés par des atomes d'oxygènes OxDF, par exemple issus de migration d'oxygène dans les régions dopées CN, PSUB de la diode PPD, qui contribuent également à l'engendrement de fuites de courant dans la jonction pn de la diode PPD faisant partie du courant d'obscurité. Or, comme mentionné précédemment, la technique de dépôt en couche atomiques ALD de l'étape 206 du procédé 200 décrit en relation avec la figure 2A, permet de former une couche de nitrure de titane dense, riche en nitrure, et pauvre en impureté, avec notamment une teneur en oxygène inférieure à 10 %, voire inférieure à 5 %, voire même inférieure à 3 %. Il est possible et probable que la faible teneur en oxygène dans les régions de couplages ohmiques RCPL résulte à une plus faible quantité d'atomes d'oxygène migrant dans les régions en silicium du substrat CN, PSUB et donc à une plus faible quantité de défauts OxDF.

Troisièmement, il existe des défauts cristallins dits « mécaniques » SiDF par exemple causés par des opérations de gravures dans le substrat PSUB, par des changements de températures en présence de matériaux ayant des coefficients de dilatation différents, par des phénomènes de migration des atomes de silicium dans le réseau cristallin, ou par d'autres causes ; qui contribuent eux-aussi à l'engendrement de fuites de courant dans la jonction pn de la diode PPD et au courant d'obscurité. Or, il est possible et probable que les conditions de l'étape de recuit 208 du procédé 200 décrit en relation avec la figure 2A, à plus grande température T pendant une durée t plus longue, permettent de « réparer » les défauts cristallins par diffusion du silicium et par redistribution des espèces dopantes dans le réseau cristallin du silicium PSUB, CN.

## Revendications

1. Circuit intégré comportant au moins une région en silicium (TG, TRG, N+, P+) et au moins un pilier métallique (CNT) en contact avec ladite région en silicium (TG, TRG, N+, P+) sur une région de couplage ohmique (RCPL), dans lequel la région de couplage ohmique (RCPL) comprend du siliciure de titane dans un volume ayant une allure de segment sphérique.

2. Circuit intégré selon la revendication 1, dans lequel le volume de la région de couplage ohmique (RCPL) a une allure de segment sphérique (SgmtS) de rayon de grand disque de base (r1) compris entre 45 nanomètres et 57 nanomètres, et de hauteur (h) comprise entre 14 nanomètres et 26 nanomètres.

3. Circuit intégré selon l'une des revendications 1 ou 2, dans lequel la région de couplage ohmique (RCPL) comprend des atomes d'oxygène en proportions inférieures à 10 %.

4. Circuit intégré selon l'une des revendications précédentes, dans lequel la région de couplage ohmique (RCPL) comprend des atomes de silicium en proportions comprises entre 60 % et 80 %.

5. Circuit intégré selon l'une des revendications précédentes, dans lequel la région de couplage ohmique (RCPL) comprend une couche de nitrure de titane (TiN) et la couche de siliciure de titane (TiSi), la partie la plus épaisse de la couche de nitrure de titane (TiN) ayant une épaisseur comprise entre 5 nanomètres et 6 nanomètres, et la partie la plus épaisse de la couche de siliciure de titane (TiSi) ayant une épaisseur comprise entre 9 nanomètres et 20 nanomètres.

6. Circuit intégré selon l'une des revendications précédentes, comportant en outre une matrice de pixels photosensibles (MPX), dans lequel la région en silicium (TG, TRG, N+, P+) est située dans la matrice de pixels photosensibles (MPX).

7. Circuit intégré selon la revendication 6, dans lequel lesdits pixels photosensibles (PX) comportent des grilles de transfert (TG) et/ou des grilles de transistors (TG) et/ou des grilles verticales enterrées (TRG) dans un substrat (PSUB), et la région en silicium est une grille de transfert (TG) ou une grille d'un transistor ou une grille verticale enterrée dans le substrat (TRG).

8. Circuit intégré selon l'une des revendications 1 à 6, dans lequel la région en silicium est du silicium dopé du type P+ (AP+) avec une concentration de dopants du type P supérieure à 10¹⁸ atomes par centimètre-cube.

9. Circuit intégré selon l'une des revendications précédentes, assemblé dans une intégration à trois dimensions de deux puces superposées (3DBSI).

10. Procédé de fabrication de circuit intégré (200) comprenant une formation d'au moins une région en silicium (TG, PSUB) et une formation d'au moins un pilier métallique (CNT) en contact avec ladite région en silicium sur une région de couplage ohmique (RCPL), la formation du pilier métallique comprenant :
- une étape (204) de dépôt d'une couche de titane (Ti) sur la région en silicium (TG, PSUB) ;
- une étape (206) de dépôt de couche atomique de nitrure de titane (TiN) sur la couche de titane (Ti) ;
- une étape (208) de recuit à une température comprise entre 715 °C et 815 °C pendant une durée comprise entre 5 secondes et 30 secondes.

11. Procédé selon la revendication 10, dans lequel la formation du pilier métallique comprend une étape de préparation (202) de surface par un plasma déporté de gaz de trifluorure d'azote et d'ammoniac sur la région en silicium (TG, PSUB), avant l'étape (204) de dépôt de la couche de titane.

12. Procédé selon l'une des revendications 10 ou 11, dans lequel la couche de titane déposée (Ti) a une épaisseur comprise entre 17,5 nanomètres et 40 nanomètres, et la couche de nitrure de titane déposée (TiN) a une épaisseur comprise entre 3 nanomètres et 6 nanomètres.

13. Procédé selon l'une des revendications 10 à 12, dans lequel la formation de ladite au moins une région en silicium (TG, PSUB) est incluse dans une fabrication d'une matrice de pixels photosensibles (MPX).

14. Procédé selon la revendication 13, dans lequel l'étape (204) de dépôt de la couche de titane comprend une utilisation d'une platine électrostatique (ElStCh) pour maintenir une plaquette semiconductrice comportant le circuit intégré.

15. Procédé selon l'une des revendications 13 ou 14, dans lequel la fabrication de la matrice de pixels photosensibles (MPX) comprend des formations de grilles de transfert (TG) et/ou de grilles de transistors (TG) et/ou des grilles verticales enterrées (TRG) dans un substrat (PSUB), ladite au moins une région en silicium étant une grille de transfert (TG) ou une grille d'un transistor ou une grille verticale enterrée dans le substrat (TRG).

16. Procédé selon l'une des revendications 10 à 15, dans lequel la formation de la région en silicium comprend une implantation de dopants de type P (AP+) dans du silicium (PSUB), avec une concentration supérieure à 10¹⁸ atomes de dopant par centimètre-cube.

17. Procédé selon l'une des revendications 10 à 16, comprenant en outre un assemblage du circuit intégré dans une intégration à trois dimensions de deux puces superposées (3DBSI).
